# EUROPÄISCHE PATENTSCHRIFT

(11) **EP 0 389 654 B1**
(45) Veröffentlichungstag und Bekanntmachung des Hinweises auf die Patenterteilung: **19.10.1994**
(21) Anmeldenummer: 89105563.4
(22) Anmeldetag: 29.03.1989
(51) Int. Cl.: H03F 1/30, H03F 3/30

(54) **Integrierbare Verstärkerschaltung**
Integrated circuit amplifier
Circuit amplificateur intégré

(43) Veröffentlichungstag der Anmeldung: 03.10.1990
(73) Patentinhaber: SIEMENS AKTIENGESELLSCHAFT, 80333 München (DE)
(72) Erfinder: Hermann, Helmut, Dipl.-Ing., D-8000 München 80 (DE); Koch, Rudolf, Dr.-Ing., D-8025 Unterhaching (DE)

(56) Entgegenhaltungen:
- EP-A- 0 143 375
- EP-A- 0 297 639
- US-A- 4 320 347
- US-A- 4 320 347
- US-A- 4 458 213
- IEEE JOURNAL OF SOLID-STATE CIRCUITS, Band SC-18, Nr. 6, Dezember 1983, Seiten624-629, IEEE, New York, US; K.E. BREHMER et al.: "Large swing CMOS poweramplifier"
- IEEE JOURNAL OF SOLID-STATE CIRCUITS, Band SC-18, Nr. 1, Februar 1983, Seiten121-127, IEEE, New York, US; V.R. SAARI: "Low-power high-drive CMOS operationalamplifiers"

## Beschreibung

Die Erfindung betrifft eine integrierbare Verstärkerschaltung nach dem Oberbegriff des Patentanspruchs 1.

Insbesondere CMOS-Operationsverstärker werden üblicherweise weitestgehend mit Stromspiegeln aufgebaut, weil damit eine geringe Empfindlichkeit der Schaltung gegenüber Parameterschwankungen erreicht wird. Es gibt auch für Leistungsverstärker, die beispielsweise als Leitungstreiber in Telecom-Bausteinen eingesetzt werden, entsprechende Konzepte. Es ist jedoch mit derartigen Schaltungen schwierig, gleichzeitig einen hohen Ansteuerbereich, eine hohe Stromergiebigkeit und eine hohe Bandbreite zu erreichen.

Eine Schaltung, die den genannten Anforderungen besser entspricht, wurde in K.J. Stern et al., A Monolithic Line Interface Circuit For T1 Terminals, Digest IEEE, Int. Solid-State-Circuits Conference, Februar 87, vorgestellt. Die Ausgangstransistoren werden hierbei nicht über Stromspiegel angesteuert, sondern mit der Ausgangsspannung von Invertern. Dadurch ist eine wesentliche höhere Aussteuerbarkeit der Ausgangstransistoren möglich. Diese können sogar in den Triodenbereich gebracht werden. Nachteilig dabei ist, daß der Ruhestrom der Ausgangsstufe ohne zusätzliche Steuerschaltung sehr stark streut (bis zu 50 % des Spitzenstromes). Bei der bekannten Schaltung werden als Dioden betrie ene Transistoren zur Begrenzung des Ruhestroms vorgeschlagen. Über Schalter werden diese Transistoren immer dann wenn kein Eingangssignal anliegt, also im Ausgangspfad nur der Ruhestrom fließen soll, aktiviert und der Ruhestrom eingestellt. Durch die geringe Verstärkung der als Dioden betriebenen Transistoren von etwa 1 ist jedoch bei dieser einfachen Steuerschaltung dennoch mit erheblichen Streuungen des Ruhestroms zu rechnen.

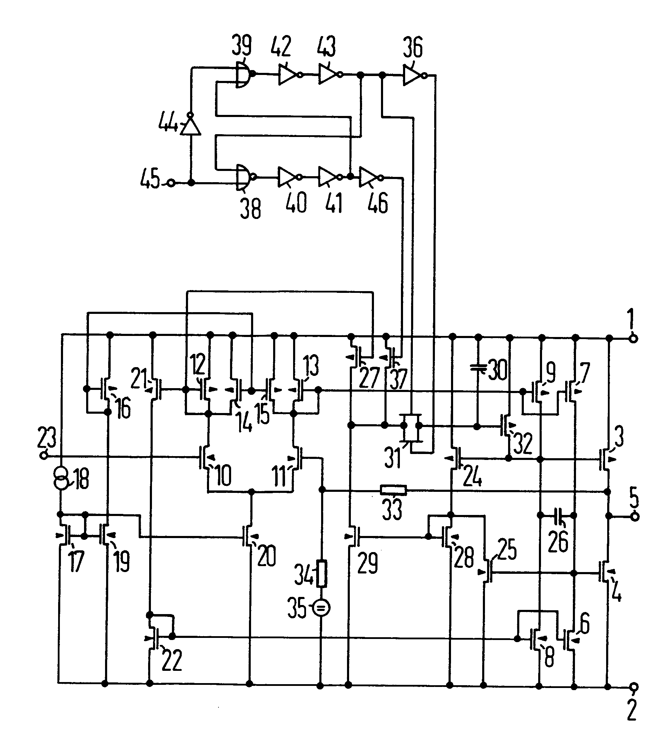

Aus der US-A-4 320 347, insbesondere Spalte 3, Zeile 50 bis Spalte 6, Zeile 7 sowie Figur 7 ist eine integrierbare Verstärkerschaltung mit Vorverstärkerstufe, Treiberstufe, einer Gegentaktendstufe sowie einer Regelstufe bekannt, bei der jedoch nur die Offsetspannung der Endstufe einstellbar ist.

Eine weitere gattungsgemäße Schaltungsanordnung ist aus der EP-A-0 143 375 bekannt. Die darin enthaltene Regelstufe bildet einen Differenzwert aus einem Referenzstrom und aus einem dem durch die Gegentaktendstufe fließenden Ruhestrom proportionalen Meßstrom, wobei von diesem Differenzwert abhängig, der Ruhestrom der Gegentaktendstufe eingestellt wird.

Aufgabe der Erfindung ist es, eine integrierbare Verstärkerschaltung anzugeben, bei der geringere Streuungen des Ruhestromes auftreten.

Diese Aufgabe wird bei einer gattungsgemäßen Verstärkerschaltung durch die kennzeichnenden Merkmale des Patentanspruches 1 gelöst. Ausgestaltungen und Weiterbildungen des Erfindungsgedankens sind in Unteransprüchen gekennzeichnet.

Der Vorteil der Erfindung liegt darin, daß mit geringem Aufwand durch den Einsatz einer Regelschleife die Schwankungen des Ruhestromes in der Ausgangsstufe sehr niedrig gehalten werden.

Die Erfindung wird nachfolgend anhand des in der einzigen FIG der Zeichnung dargestellten Ausführungsbeispiels näher erläutert.

Das Ausführungsbeispiel gemäß der Zeichnung umfaßt eine Gegentaktendstufe mit einem sourceseitig an einem positiven ersten Betriebspotential 1 liegenden PMOS-Transistor 3 und mit einem sourceseitig an einem negativen zweiten Betriebspotential 2 liegenden NMOS-Transistor 4, deren Drainanschlüsse zusammengeführt sind und den Ausgang 5 der Verstärkerschaltung bilden. Die Gateanschlüsse der Transistoren 3 und 4 sind jeweils an den Ausgang einer Gegentaktstufe angeschlossen. Die beiden Gegentaktstufen bilden zusammen eine Treiberstufe für die Gegentaktendstufe und weisen jeweils einen PMOS-Transistor 7 bzw. 9 und einen NMOS-Transistor 6 bzw. 8 auf. Die Sourceanschlüsse der Transistoren 7 und 9 sind dabei mit dem ersten Betriebspotential 1 und die Sourceanschlüsse der Transistoren 6 und 8 sind mit dem zweiten Betriebspotential 2 beaufschlagt. Die Drainanschlüsse der Transistoren 6 und 7 sind zusammengeschaltet und mit dem Gateanschluß des Transistors 4 verbunden. Desgleichen sind die Drainanschlüsse der Transistoren 8 und 9 zusammengeführt und mit dem Gateanschluß des Transistors 3 verbunden.

Als Vorverstärkerstufe ist in Ausgestaltung der Erfindung ein Operational-Transconductance-Amplifier vorgesehen, welcher bevorzugt aufgrund seiner Schnelligkeit und der Möglichkeit, ohne großen Aufwand Ströme auszuleiten, angewandt wird. Dieser weist zwei sourcegekoppelte NMOS-Transistoren 10 und 11 auf, in deren Drainkreisen jeweils durch Verbinden von Drain- und Sourceanschluß ein als Diode in Durchlaßrichtung betriebener Transistor 12 bzw. 13 liegt. Der Drain-Source-Strecke des Transistors 12 bzw. 13 ist jeweils die Drain-Source-Strecke eines Transistors 14 bzw. 15 parallel geschaltet, wobei die miteinander verbundenen Gateanschlüsse der Transistoren 14 und 15 zum einem über einen durch Verbinden von Drain- und Gateanschluß als Diode in Durchlaßrichtung betriebenen PMOS-Transistor 16 auf das erste Betriebspotential 1 geführt und zum anderen an einen auf das zweite Betriebspotential 2 bezogenen ersten Stromspiegel angeschlossen sind. Dieser erste Stromspiegel weist einen durch Verbinden von Drain- und Gateanschluß als Diode in Durchlaßrichtung betriebenen NMOS-Transistor 17 auf, der mit einer an dem ersten Betriebspotential 1 liegenden Stromquelle 18 und mit einem Transistor 19, dessen Gateanschluß mit dem Gateanschluß des Transistors 17 und dessen Drainanschluß mit dem Drainanschluß des Transistors 16 verschaltet ist, verbunden ist. An den Gateanschluß des Transistors 17 ist auch der Gateanschluß eines NMOS-Transistors 20 geführt, dessen Drainanschluß mit den gekoppelten Sourceanschlüssen der Transistoren 10 und 11 verbunden ist und dessen Sourceanschluß ebenso wie die Sourceanschlüsse der Transistoren 17 und 19 an dem zweiten Betriebspotential 2 liegen.

Die Ankopplung der Treiberstufe an die Vorverstärkerstufe erfolgt zum einen über eine direkte Verbindung zwischen dem Drainanschluß des Transistors 11 und dem Gateanschluß der Transistoren 7 und 9 und zum anderen durch einen PMOS-Transistor 21, dessen Gateanschluß mit dem Drainanschluß des Transistors 10 und dessen Drainanschluß mit dem Gateanschluß der Transistoren 6 und 8 verbunden ist. Darüber hinaus sind die Gateanschlüsse der Transistoren 6 und 8 über einen durch Verbinden von Gate- und Drainanschluß als Diode in Durchlaßrichtung betriebenen NMOS-Transistors 22 auf das zweite Betriebspotential 2 geführt. Der Sourceanschluß des Transistors 21 ist ebenso wie die Sourceanschlüsse der Transistoren 12, 13, 14 und 15 mit dem ersten Betriebspotential 1 beaufschlagt. Als nichtinvertierender Eingang 23 der Verstärkerschaltung ist der Gateanschluß des Transistors 10 und als invertierender Eingang der Gateanschluß des Transistors 11 vorgesehen.

Erfindungsgemäß umfaßt die in der Zeichnung dargestellte Verstärkerschaltung eine Regelstufe. Diese enthält beispielsweise eine weitere Gegentaktstufe mit einem PMOS-Transistor 24 und einen NMOS-Transistor 25, die der Gegentaktendstufe eingangsseitig parallel geschaltet ist. Der Gateanschluß des Transistors 24 ist dabei mit dem einen Gegentakteingang der Gegentaktendstufe darstellenden Gateanschluß des Transistors 3 und der Gateanschluß des Transistors 25 mit dem den anderen Gegentakteingang darstellenden Gateanschluß des Transistors 4 verbunden. Zwischen die beiden oben beschriebenen Gegentakteingänge ist die Erfindung weiterbildend ein Kondensator 26 geschaltet. Das bringt den Vorteil einer höheren Stabilität des Regelkreises mit sich. Der durch die gekoppelten Drainanschlüsse der Transistoren 24 und 25 gebildete Ausgang der weiteren Gegentaktstufe ist auf den Eingang eines auf das zweite Betriebspotential 2 bezogenen zweiten Stromspiegels geführt, dessen Ausgang über die Drain-Source-Strecke eines PMOS-Transistors 27 an dem ersten Betriebspotential 1 liegt. Als Eingang des zweiten Stromspiegels ist der gekoppelte Drain- und Gateanschluß eines als Diode in Durchlaßrichtung betriebenen auf das zweite Betriebspotential 2 führenden NMOS-Transistors 28 und als Ausgang des zweiten Stromspiegels ist der Drainanschluß eines sourceseitig an dem zweiten Betriebspotential 2 liegenden und gateseitig mit dem Eingang des zweiten Stromspiegels verbundene NMOS-Transistor 29 vorgesehen. Darüber hinaus enthält die Regelstufe des Ausführungsbeispiels eine Sample-and-Hold-Schaltung mit einem Speicherkondensator 30, der einerseits über ein Transmissiongate 31 auf den Ausgang des zweiten Stromspiegels aufschaltbar ist und zum anderen an dem ersten Betriebspotential 1 liegt sowie mit einem sourceseitig mit dem ersten Betriebspotential 1 beaufschlagten PMOS-Transistor 32 verbunden ist. Die Drain-Source-Strecke des Transistors 32 ist zur Arbeitspunktveränderung der Gegentaktendstufe zwischen Gateanschluß des Transistors 3 und das erste Betriebspotential 1 geschaltet. Die Regelstufe stellt jedoch nur den Ruhestrom eines Zweiges der Gegentaktendstufe, nämlich des Zweiges mit dem Transistor 3, ein. Die Erfindung weiterbildend ist daher ein Gegenkopplungsnetzwerk beispielsweise zwischen Ausgang der Gegentaktendstufe und dem invertierendem Eingang der Verstärkerstufe vorgesehen, welches einen den Ausgang der Gegentaktendstufe mit dem invertierenden Eingang der Vorverstärkerstufe verbindenden Widerstand 33 und einen den invertierenden Eingang mit einer auf das erste Betriebspotential 1 bezogenen Spannungsquelle 35 verbindenden Widerstand 34 aufweist. Der Vorteil dieser Ausführungsform liegt darin, daß zum einen ein geringerer Aufwand nötig ist, da eine Regelung für den zweiten Zweig, im gezeigten Ausführungsbeispiel für Transistor 4, entfällt und zum anderen dadurch eine höhere Stabilität des Regelkreises gewährleistet wird, da zwei Regelschleifen gegeneinander arbeiten würden. Darüber hinaus ist die Erfindung weiterbildend der in den Transistor 27 fließende Referenzstrom von dem am Eingang der Vorverstärkerstufe anliegenden Signal abhängig, in dem nämlich der Gateanschluß des Transistors 27 ebenfalls an den Drainanschluß des Transistors 12 angeschlossen ist. Dadurch wird vorteilhafterweise erreicht, daß auch bei eingeschaltetem Regelkreis eine Aussteuerung des Ausgangs möglich ist und eventuelle Störungen oder Einkopplungen in den Ausgang rasch ausgeglichen werden können. Die Ansteuerung der Gateanschlüsse des Transmissiongates 31 erfolgt gegenphasig. Deshalb wird ein Gateanschluß direkt und der andere Gateanschluß über einen Inverter 36 durch ein Steuersignal angesteuert. Mit dem Steuersignal ist ebenfalls ein PMOS-Transistor 37 gateseitig beaufschlagt. Die Source-Drain-Strecke des Transistors 37 ist der Source-Drain-Strecke des Transistors 27 parallel geschaltet. Der Vorteil liegt darin, daß während der Zeit, in der das Transmissiongate 31 gesperrt ist, also bei abgeschalteter Regelung, das Drainpotential des Transistors 29 auf einen definierten Wert, nämlich annähernd auf das erste Betriebspotential 1 gelegt ist.

Bevorzugt werden Transistor 37 und Transmissiongate 31 derart angesteuert, daß sich die Schaltflanken beider nicht überlappen.

Dadurch wird vorteilhafterweise ausgeschlossen, daß beim Übergang von der Sample- in die Holdphase der Speicherkondensator 30 über das Transmissiongate 31 und den Transistor 37 kurzgeschlossen wird. Eine Steuerstufe zur Verhinderung von sich überlappenden Schaltflanken umfaßt beispielsweise zwei NOR-Gatter 38, 39, deren Ausgänge jeweils zunächst über zwei Inverter 40, 41 bzw. 42, 43 führen und dann mit jeweils einem Eingang des anderen NOR-Gatters 39 bzw. 38 verbunden sind. Der andere Eingang des NOR-Gatters 38 ist dabei direkt und der andere Eingang des NOR-Gatters 39 über einen Inverter 44 mit dem Steuereingang 45 verbunden. Der Ausgang des Inverters 41 ist über einen Inverter 46 auf den Gateanschluß des Transistors 37 geführt, während der Ausgang des Inverters 43 mit einem Gateanschluß des Transmissiongates 31 und dem Eingang des Inverters 36 verbunden ist.

Die Schwankungen des Ruhestromes werden bei der erfindungsgemäßen Verstärkerschaltung sehr gering gehalten durch den Einsatz einer Regelschleife mit vergleichsweise hoher Verstärkung von beispielsweise größer 10. Ein Referenzstrom für das Soll-Niveau des Ruhestromes wird über den aus den Transistoren 12 und 27 bestehenden Stromspiegel von der Differenzstufe des Operational-Transconductance Amplifiers mit den Transistoren 20, 10 und 11 abgeleitet. Das Ist-Niveau des Stromes im Transistor 3 wird durch den Transistor 24 nachgebildet und über den aus den Transistoren 28 und 29 bestehenden Stromspiegel mit dem in dem Transistor 27 fließenden Referenzstrom verglichen. Die Differenz von Referenzstrom und einem dem Ruhestrom proportionalen Meßstrom steuert über das Transmissiongate 31 den als Stellglied wirkenden Transistor 32, der durch Verändern des Gatepotentiales von Transistor 3 dessen Ruhestrom einstellt. Der Ruhestrom des Transistors 4 wird dagegen über die Gegenkopplung der gesamten Verstärkerschaltung mit den Widerständen 33 und 34 angeglichen. Ein Unterschied in den Ruheströmen der Transistoren 3 und 4 bzw. der Transistoren 24 und 25 bewirkt eine Spannung am Ausgang 5, die über das Gegenkopplungsnetzwerk auf den invertierenden Eingang der Vorverstärkerstufe wirkt und somit die Ruheströme ausgleicht.

Durch geeignete Ansteuerung des Transmissiongates 31 wird erreicht, daß der Ruhestrom nur in den Phasen gemessen wird, in denen das Eingangssignal Null anliegt und in der Gegentaktendstufe somit nur der Ruhestrom fließen soll. Während der übrigen Zeit wird die entsprechende Ansteuerspannung für den Transistor 32 durch den Speicherkondensator 30 gehalten. Aufgrund der aus Stabilitätserwägungen notwendigerweise unterschiedlichen Zeitkonstanten der inneren Regelschleife für den Ruhestrom des Transistors 3 und der äußeren Regelschleife über die gesamte Verstärkerschaltung für den Ruhestrom des Transistors 4 ist es möglich, daß beim Anschalten der Regelung transiente Störer am Ausgang entstehen. Um diese transienten Störungen zu minimieren, wird das Zuregeln des Stromes im Transistor 3 etwas verlangsamt beispielsweise durch entsprechend hochohmige Dimensionierung des Transfergatters 31 und/oder die Erfindung ausgestaltend durch Klemmen des Drainanschlusses des Transistors 29 gegen das erste Betriebspotential 1 solange die Regelschleife inaktiv ist. Ferner wird als zweite, untergeordnete Regelgröße das Verhältnis zwischen den Strömen der Transistoren 3 und 4 eingeführt. Dazu dient der Transistor 25.

Um die Stabilität der Regelung zu garantieren ist eine Kompensation mit dem Kondensator 26 zwischen den beiden Gegentakteingängen der Gegentaktendstufe vorteilhaft. Auf die Regelung bezogen arbeiten diese Knoten gegenphasig, so daß die Wirkung des Kondensators vergrößert wird (Miller-Effekt), während auf das Signal bezogen diese Knoten gleichphasig arbeiten und somit der Signalpfad in seiner Geschwindigkeit von dem Kondensator 26 nicht beeinflußt wird.

Anschließend sei bemerkt, daß eine Realisierung nicht auf die MOS-Technik beschränkt ist, sondern etwa auch in Bipolar-Technik oder in Mischtechniken möglich ist.

## Patentansprüche

1. Integrierbare Verstärkerschaltung mit einer Vorverstärkerstufe, einer Treiberstufe, einer Gegentaktendstufe und einer Regelstufe (24, 25, 27, 28, 29, 30, 31, 32), die einen Differenzwert aus einem Referenzstrom und aus einem dem durch die Gegentaktendstufe (3, 4) fließenden Ruhestrom proportionalen Meßstromes bildet,
**dadurch gekennzeichnet**, daß die Regelstufe bei Auftreten eines das Nichtaussteuern der Vorverstärkerstufe anzeigenden Steuersignals an einem Steuereingang den Differenzwert oder einen dazu proportionalen Wert speichert und abhängig vom gespeicherten Wert durch Andern des Arbeitspunktes der Gegentaktendstufe deren Ruhestrom einstellt, wobei die Vorverstärkerstufe als Operational-Transconductance Amplifier (10...22) ausgebildet ist, deren Ausgangsstrom als Referenzstrom dient.

2. Verstärkerschaltung nach Anspruch 1,
**dadurch gekennzeichnet**, daß durch die Regelstufe (24, 25, 27, 28, 29, 30, 31, 32) lediglich der Ruhestrom eines Zweiges (3) der Gegentaktendstufe (3, 4) einstellbar ist und daß ein Gegenkopplungsnetzwerk (33, 34) zwischen Ausgang der Gegentaktendstufe (3, 4) und Eingang der Vorverstärkerstufe (10...22) zur Einstellung des Ruhestromes des anderen Zweiges vorgesehen ist.

3. Verstärkerschaltung nach Anspruch 1 oder 2,
**dadurch gekennzeichnet**, daß der Referenzstrom von dem am Eingang der Vorverstärkerstufe (10...22) anliegenden Signal abhängig ist.

4. Verstärkerschaltung nach einem der Ansprüche 1 bis 3,
**dadurch gekennzeichnet**, daß zur Speicherung des Differenzwertes oder des dazu proportionalen Wertes bei der Regelstufe eine Sample-and-Hold-Schaltung (30, 31, 32) vorgesehen ist.

5. Verstärkerschaltung nach einem der Ansprüche 1 bis 4,
**gekennzeichnet durch** einen zwischen die Gegentakteingänge der Gegentaktendstufe (3, 4) geschalteten Kondensator (26).

6. Verstärkerschaltung nach einem der Ansprüche 1 bis 5,
**gekennzeichnet durch** einen ersten Transistor (32), dessen Drainanschluß an einem der beiden Gegentakteingänge der Gegentaktendstufe (3, 4) und dessen Sourceanschluß an ein erstes Betriebspotential (1) angeschlossen ist,
durch einen Speicherkondensator (30), der zwischen Gate- und Sourceanschluß des ersten Transistors (32) geschaltet ist, durch eine Gegentaktstufe (24, 25) deren Gegentakteingänge den Gegentakteingängen der Gegentaktendstufe (3, 4) parallelgeschaltet sind,
durch einen auf ein zweites Betriebspotential bezogenen Stromspiegel, dessen Eingang mit dem Ausgang der Gegentaktendstufe (24, 25) verschaltet ist,
durch ein Transmissiongate (31), dessen Drain-Source-Strecke zwischen den Ausgang des Stromspiegels und den Gateanschluß des ersten Transistors (32) geschaltet ist und dessen Gate-anschlüsse zueinander gegenphasig mit dem Steuereingang (45) gekoppelt sind und
durch einen den Referenzstrom führenden zweiten Transistor (27), dessen Sourceanschluß an dem ersten Betriebspotential (1) und dessen Drainanschluß an dem Ausgang des Stromspiegels (28, 29) angeschlossen ist, als Regelstufe.

7. Verstärkerschaltung nach Anspruch 6,
**dadurch gekennzeichnet**, daß der Drain-Source-Strecke des zweiten Transistor (27) die Drain-Source-Strecke eines dritten Transistors (37) parallelgeschaltet ist, dessen Gateanschluß mit dem Steueranschluß 45 gekoppelt ist.

8. Verstärkerschaltung nach Anspruch 7,
**dadurch gekennzeichnet**, daß die Gateanschlüsse des Transmissiongates (31) sowie der Gateanschluß des dritten Transistors (37) über eine Steuerstufe (38...44, 46, 36) zur Verhinderung von sich überlappenden Schaltflanken bei der Ansteuerung des Transmissiongates (31) und des dritten Transistors (37) mit dem Steuereingang (45) gekoppelt sind.

## Claims

1. Amplifier circuit which can be integrated and has a preamplifier stage, a driver stage, a push-pull output stage and a control stage (24, 25, 27, 28, 29, 30, 31, 32) which forms a difference value from a reference current and a measurement current which is proportional to the quiescent current flowing through the push-pull output stage (3, 4), characterized in that the control stage stores the difference value or a value proportional thereto in the event of a control signal, which indicates that the preamplifier stage is not being driven, occurs on a control input, and adjusts the quiescent current of the push-pull output stage as a function of the stored value, by changing the operating point of said push-pull output stage, the preamplifier stage being constructed as an operational transconductance amplifier (10...22) whose output current is used as the reference current.

2. Amplifier circuit according to Claim 1, characterized in that only the quiescent current of one branch (3) of the push-pull output stage (3, 4) can be adjusted by means of the control stage (24, 25, 27, 28, 29, 30, 31, 32), and in that a negative feedback network (33, 34) is provided between the output of the push-pull output stage (3, 4) and the input of the preamplifier stage (10...22), in order to adjust the quiescent current in the other branch.

3. Amplifier circuit according to Claim 1 or 2, characterized in that the reference current is dependent on the signal applied to the input of the preamplifier stage (10...22).

4. Amplifier circuit according to one of Claims 1 to 3, characterized in that a sample and hold circuit (30, 31, 32) is provided in order to store the difference value or the value proportional thereto, in the control stage.

5. Amplifier circuit according to one of Claims 1 to 4, characterized by a capacitor (26) which is connected between the push-pull inputs of the push-pull output stage (3, 4).

6. Amplifier circuit according to one of Claims 1 to 5, characterized by a first transistor (32) whose drain connection is connected to one of the two push-pull inputs of the push-pull output stage (3, 4) and whose source connection is connected to a first operating potential (1), by an energy-storage capacitor (30) which is connected between the gate and source connections of the first transistor (32), by a push-pull stage (24, 25) whose push-pull inputs are connected in parallel with the push-pull inputs of the push-pull output stage (3, 4), by a current mirror circuit which is related to a second operating potential and whose input is wired to the output of the push-pull output stage (24, 25), by a transmission gate (31) whose drain-source junction is connected between the output of the current mirror circuit and the gate connection of the first transistor (32) and whose gate connections are coupled, in antiphase with respect to one another, to the control input (45), and by a second transistor (27), carrying the reference current, whose source connection is connected to the first operating potential (1) and whose drain connection is connected to the output of the current mirror circuit (28, 29), as the control stage.

7. Amplifier circuit according to Claim 6, characterized in that the drain-source junction of the second transistor (27) is connected in parallel with the drain-source junction of a third transistor (37) whose gate connection is coupled to the control connection (45).

8. Amplifier circuit according to Claim 7, characterized in that the gate connections of the transmission gate (31) and the gate connection of the third transistor (37) are coupled to the control input (45) via a control stage (38...44, 46, 36), in order to prevent mutually overlapping switching edges when the transmission gate (31) and the third transistor (37) are being driven.

## Revendications

1. Circuit amplificateur intégrable comportant un étage préamplificateur, un étage d'attaque, un étage final symétrique et un étage de régulation (24, 25, 27, 28, 29, 30, 31, 32) qui forme une valeur différentielle à partir d'un courant de référence et d'un courant de mesure, qui est proportionnel au courant de repos traversant l'étage final symétrique (3, 4),
caractérisé par le fait que lors de l'apparition à une entrée de commande, d'un signal de commande, indiquant une absence de modulation de l'étage préamplificateur, I'étage de régulation mémorise la valeur différentielle ou une valeur proportionnelle à cette valeur et règle le courant de repos de l'étage final symétrique en fonction de la valeur mémorisée, par modification du point de fonctionnement de cet étage, I'étage préamplificateur étant réalisé sous la forme d'un amplificateur opérationnel à transconductance (10...22), dont le courant de sortie est utilisé en tant que courant de référence.

2. Circuit amplificateur suivant la revendication 1, caractérisé par le fait que l'étage de régulation (24, 25, 27, 28, 29, 30,31, 32) permet de régler seulement le courant de repos d'une branche (3) de l'étage final symétrique (3, 4) et qu'un réseau de contre-réaction (33, 34) est prévu entre la sortie de l'étage final symétrique (3, 4) et l'entrée de l'étage préamplificateur (10...22) pour le réglage du courant de repos de l'autre branche.

3. Circuit amplificateur suivant la revendication 1 ou 2, caractérisé par le fait que le courant de référence dépend du signal appliqué à l'entrée de l'étage préamplificateur (10...22).

4. Circuit amplificateur suivant l'une des revendications 1 à 3, caractérisé par le fait que pour la mémorisation de la valeur différentielle ou de la valeur qui est proportionnelle à cette valeur, un circuit d'échantillonnage et de blocage (30, 31, 32) est prévu dans l'étage de régulation.

5. Circuit amplificateur suivant l'une des revendications 1 à 4, caractérisé par un condensateur (28) branché entre les entrées en opposition de phase de l'étage final symétrique (3, 4).

6. Circuit amplificateur suivant l'une des revendications 1 à 5, caractérisé par un premier transistor (32), dont la borne de drain est reliée à l'une des deux entrées en opposition de phase de l'étage final symétrique (3, 4) et dont la borne de source est placée à un premier potentiel de service (1),
par un condensateur de stockage (30), qui est branché entre la borne de grille et la borne de source du premier transistor (32),
par un étage symétrique (24, 25), dont les entrées en opposition de phase sont branchées en parallèle avec les entrées en opposition de phase de l'étage final symétrique (3, 4),
par un miroir de courant rapporté à un second potentiel de service et dont l'entrée est connectée à la sortie de l'étage final symétrique (24, 25),
par une porte de transmission (31), dont la voie drain-source est branchée entre la sortie du miroir de courant et la borne de grille du premier transistor (32) et dont les bornes de grille sont couplées en opposition de phase à l'entrée de commande (45), et
par un second transistor (27), qui applique le courant de référence et dont la borne de source est raccordée au premier potentiel de service (1) et dont la borne de drain est raccordée à la sortie du miroir de courant (28, 29), en tant qu'étage de régulation.

7. Circuit amplificateur suivant la revendication 6, caractérisé par le fait qu'en parallèle avec la voie drain-source du second transistor (27), est branché la voie drain-source d'un troisième transistor (37), dont la borne de grille est couplée à la borne de commande (45).

8. Circuit amplificateur suivant la revendication 7, caractérisé par le fait que les bornes de grille de la porte de transmission (31) ainsi que la borne de grille du troisième transistor (37) sont couplées à l'entrée de commande (45), par l'intermédiaire d'un étage de commande (38...44, 46, 36), pour empêcher l'apparition de flancs de commutation se chevauchant, lors de la commande de la porte de transmission (31) et du troisième transistor (37).
